# EUROPEAN PATENT APPLICATION

(11) **EP 2 025 434 A1**
(43) Date of publication of application: **18.02.2009**
(21) Application number: 08252466.1
(22) Date of filing: 18.07.2008
(51) Int. Cl.: B22D 27/04, B22C 9/04, C30B 11/00, C30B 11/14

(54) **Preformed ceramic seed well for single crystal starter seed**

(30) Priority: 18.07.2007 US 879770
(71) Applicant: United Technologies Corporation, Hartford, CT 06101 (US)
(72) Inventor: Sauerhoefer, Marc, Coventry, CT 06238 (US); Marcin, John, Marlborough, CT 06447 (US); Kennard, Lea D., Manchester, CT 06042 (US); Turkington, Michael, Manchester, CT 06040 (US); Bullied, Steven, Pomfret, CT 06259 (US); Murray, Stephen, Stafford Springs, CT 06076 (US)
(74) Representative: Tomlinson, Kerry John

(57) **Abstract**

A method of creating an article from investment casting includes forming a ceramic seed well (10), heating the ceramic seed well to form a hardened ceramic seed well (10), attaching a meltable pattern (30) to the hardened ceramic seed well (10), coating the hardened ceramic seed well and the meltable pattern with hardenable ceramic material (42), heating the hardenable ceramic material to melt the meltable pattern (30), removing the meltable pattern from the hardenable ceramic material (42), firing the hardenable ceramic material to form a ceramic mold (64) having a cavity (74), placing a seed (12) within the hardened ceramic seed well, and pouring molten metal (62) into the hardened ceramic seed well (10) and the cavity (74). The cavity of the ceramic mold is in communication with the hardened ceramic seed well (10).

## Description

### BACKGROUND OF THE INVENTION

The present invention relates generally to the field of investment casting. In particular, the present invention relates to shell-mold investment casting.

Investment casting is one of the primary manufacturing processes used in the fabrication of aerospace hardware with high technology content. These products are typically operated in extreme environments, such as the hot section of a turbine engine, and are exposed to high temperatures and high stresses. In the most demanding applications, designs require the utilization of single crystal superalloys. One of the considerations when designing products for these applications is the orientation of the crystal axis of the alloys. By orienting the axis in a particular direction, the properties of the end product may be manipulated to better fit the desired specifications. This may be accomplished in the casting process through a seeding technique where a directionally solidified casting is seeded with an alloy similar in melting point as the metal to be cast but of known orientation. The casting is grown from the metal seed by melting back a portion of the seed and capturing the underlying crystal structure through epitaxial growth during the casting process.

Shell-mold investment casting is a manufacturing process by which near-net shaped articles may be fabricated while controlling both the microstructure and crystallographic orientation of the basic structure. The primary and secondary orientations of the basic arrangement of atoms, as a unit cell and a larger material lattice (stacked unit cells), are significant to the characterization of the material and subsequently to the properties of the cast component. These orientations are defined by the orientation of the seed crystal. Traditionally, the shell-mold base cavity ("seed well") is fabricated in the same manner as the shell mold parts, by using a wax pattern. The seed well is formed using a wax pattern to replicate seed geometry, shelling over the wax with ceramic, and then removing the wax. After evacuation of the wax pattern from the mold, a cavity is left in which to place a pre-made seed with a known orientation that has already been previously established.

Assembly of a pre-oriented seed of the parent material within the seed well is well-established in current industry practice as providing an initiation point of crystal growth. The seeds are typically a cast bar with a known primary and secondary crystal orientation that are cut and finished to a prescribed length depending on the configuration of the mold-height and the height capacity of the furnace. These metal seeds can take a variety of shapes, including, but not limited to: rectangular, cylindrical, conical, or a variety of other extruded geometric shapes. Crystal growth proceeds along a solidification front from a zone containing the seed's uppermost surface which has been melted back a prescribed distance as heat is directionally extracted from the metal seed inside the seed well in a predominant direction.

While effective, this method of forming the seed well results in a stack up of tolerances and shrink factors, requiring a process that must be constantly monitored. Even with precise monitoring, there may still be variations between the dimensions of the seed and the seed well, leading to difficulty in placing the seed in the seed well. The mismatch between the seed and the seed well may be caused by variability in the seed-wall pattern and subsequent shell, in the wax seed pattern and subsequent shell, and the casting process. The inability to accurately place and locate the seed in the seed well can lead to an improper crystallization start, improper orientation, improper melt-back location, and contamination due to force-fitting. Attempts to fix these problems have involved sanding and finishing the seed well, adjustments to the seed, or material removal of the seed dimensions. What is needed is an improved seed well for use in investment casting.

### BRIEF SUMMARY OF THE INVENTION

A method of creating an article from investment casting includes forming a ceramic seed well, heating the ceramic seed well to form a hardened ceramic seed well, attaching a meltable pattern over the hardened ceramic seed well, coating the hardened ceramic seed well and the meltable pattern with hardenable ceramic material, heating the hardenable ceramic material to melt the meltable pattern, removing the meltable pattern from the hardenable ceramic material, firing the hardenable ceramic material to form a ceramic mold having a cavity, placing a seed within the hardened ceramic seed well, and pouring molten metal into the hardened ceramic seed well and the cavity. The cavity of the ceramic mold is in communication with the hardened ceramic seed well.

According to the invention, an investment casting process comprises attaching a first wax pattern to a first preformed seed well; coating the first wax pattern and the first preformed seed well with at least one layer of ceramic material to form a first ceramic mold; heating the first ceramic mold to melt and remove the first wax pattern; firing the first ceramic mold to form a first hardened ceramic shell; placing a first seed within the first preformed seed well; and pouring molten metal into the first hardened ceramic shell and the first preformed seed well.

### BRIEF DESCRIPTION OF THE DRAWINGS

FIG. 1 is a cross-sectional view of a preformed ceramic seed well.
FIG. 2 is a schematic view of a first step in an investment casting process.
FIG. 3 is a schematic view of a second step in an investment casting process using a first embodiment of a fixture.
FIG. 3A is a schematic view of the second step in the investment casting process using a second embodiment of a fixture.
FIG. 4 is a schematic view of a third step in the investment casting process.
FIG. 5 is a diagram of a method of fabricating a casting using a preformed ceramic seed well.

### DETAILED DESCRIPTION

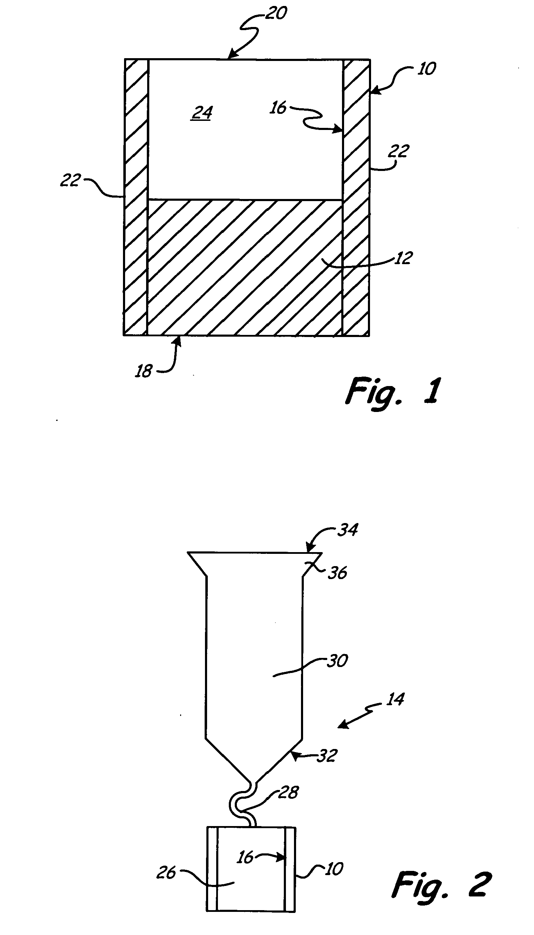

FIG. 1 shows a cross-sectional view of preformed ceramic seed well 10 and pre-oriented seed 12 used in investment casting process 14. Prefabrication of ceramic seed well 10 eliminates process variations that lead to dimensional mismatches between ceramic seed well 10 and seed 12 when wax is used to form ceramic seed well 10. For example, variations can occur in the wax seed-pattern, shell build, and shell cure process. Ceramic seed well 10 is dimensionally accurate with respect to seed 12 and produces precise geometric placement and location of seed 12. In addition, prefabrication may further customize the thermal conditions adjacent to seed 12 for enhanced melt back control by controlling the thickness of ceramic seed well 10. By injecting and firing a preformed ceramic seed well 10 out of ceramic and assembling ceramic seed well 10 onto a mold pattern, several tolerances and shrinkages are removed, leading to a tighter, more consistent fit of seed 12 within seed well 10. Ceramic seed well 10 provides for a preformed geometry that allows enhanced flow across the surface of seed 12, which may also reduce localized oxidation. By eliminating dimensional mismatching, yields on expensive cast parts may be increased and manufacturing costs may be reduced. The cast articles may be subsequently used, for example, in turbine and combustor sections of a gas turbine engine.

Ceramic seed well 10 is hollow and has inner surface 16, first end 18, second end 20, and walls 22. Because ceramic seed well 10 is hollow, walls 22 form an inner area 24 defined by inner surface 16. Ceramic seed well 10 is preformed from ceramic such that the inner dimensions of ceramic seed well 10 are substantially the same as the dimensions of seed 12. In an exemplary embodiment, ceramic seed well 10 may be formed of alumina or alumino-silicate for directional solidification, columnar grained, or single crystal (DS/SX) parts or zirconia silicate ceramic for equiaxed parts. Although ceramic seed well 10 is discussed as being formed of ceramic, ceramic seed well 10 may be formed of any material that does not react with the molten metal that is subsequently poured into ceramic seed well 10 and that has a melting point higher than the melting point of the molten metal. For example, ceramic seed well 10 may be formed of materials including, but not limited to: ceramic, metallic, and composite material. In addition, although FIG. 1 depicts ceramic seed well 10 as being rectangular in shape, ceramic seed well 10 may take any shape without departing from the intended scope of the present invention as long as seed 12 fits precisely within inner area 24. In an exemplary embodiment, ceramic seed well 10 is formed through an extrusion process.

Seed 12 is sized to fit precisely within inner area 24 of ceramic seed well 10, although ceramic seed well 10 will have a greater height than seed 12. Seed 12 has known primary and secondary orientations and is typically machined from a pre-existing single crystal of the same material or a material having a similar melting point as the molten metal used in investment casting process 14. Multiple seeds may also be investment cast from a master seed.

A crucial parameter in the seeding process involves preventing the formation of a gap between seed 12 and walls 22 of ceramic seed well 10. If interior area 24 of ceramic seed well 10 is too small, seed 12 will not be able to be positioned within ceramic seed well 10. If interior area 24 is too large, molten metal will pass around seed 12 during the casting process and seed 12 may not be properly replicated. By preforming ceramic seed well 10 through an extrusion, slip cast, or injection process, shrinkage problems during investment casting process 14 can be prevented.

FIG. 2 shows a schematic view of a first step of investment casting process 14 using preformed ceramic seed well 10. The first step in investment casting process 14 generally includes preformed ceramic seed well 10, wax plug 26, wax gating 28, and wax pattern 30. To maintain the shape and dimensions of ceramic seed well 10 after manufacture, ceramic seed well 10 is fired. After ceramic seed well 10 is in a hardened state, wax plug 26 is inserted within ceramic seed well 10. Wax plug 26 will sufficiently conform to interior area 24 of ceramic seed well 10 to prevent ceramic penetration into interior area 24 of ceramic seed well 10. Although FIG. 2 discusses a wax plug 26 being inserted within ceramic seed well 10, ceramic seed well 10 may be blocked off by any means known in the art to prevent ceramic from getting into interior area 24 of ceramic seed well 10, including, but not limited to: capping off the top of ceramic seed well 10 with a ceramic sheet.

Once wax plug 26 has plugged ceramic seed well 10, wax gating 28 is positioned over wax plug 26. Wax gating 28 may be attached to wax plug 26 by any means known in the art, including, but not limited to: an adhesive such as glue or by wax welding. In an exemplary embodiment, wax gating 28 has a helical shape. However, wax gating 28 may take any variety of shapes and sizes known in the art. Wax pattern 30 has a first end 32 connected to wax gating 28 and a second end 34. Second end 34 of wax pattern 30 may optionally be provided with pour cup 36. Pour cup 36 may be formed of wax or ceramic. Although wax gating 28 and wax pattern 30 are discussed as being separate pieces, wax gating 28 and wax pattern 30 may formed as a single piece without departing from the intended scope of the present invention.

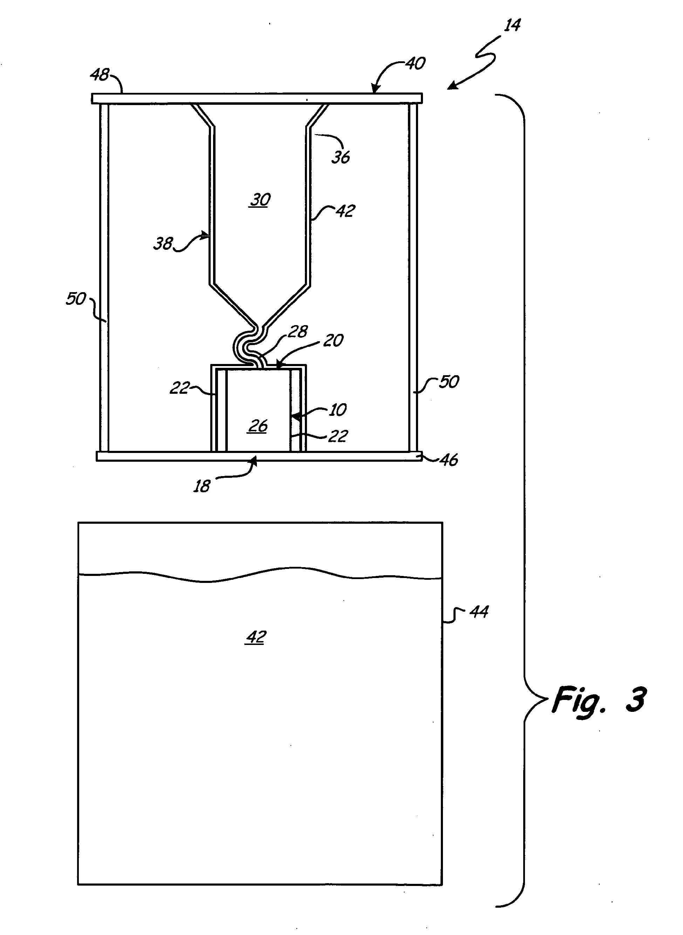

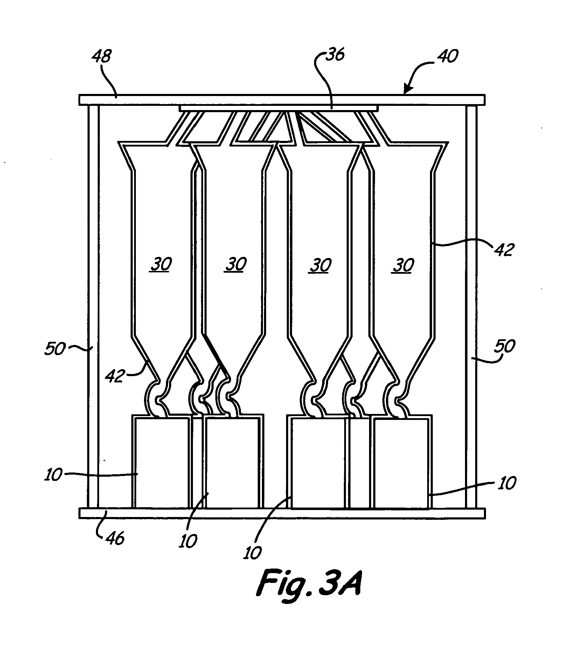

FIG. 3 shows a schematic view of a second step of investment casting process 14. The second step of investment casting process 14 generally includes ceramic seed well 10, wax plug 26, wax gating 28, wax pattern 30, and wax pour cup 36 which collectively will be referred to as wax mold 38, fixture 40, ceramic material 42, and slurry tank 44. Once wax plug 26 within ceramic seed well 10 is properly attached to wax gating 28, wax pattern 30, and wax pour cup 36 to form a single piece (wax mold 38), wax mold 38 is positioned within fixture 40 for dipping into ceramic material 42 in slurry tank 44.

Fixture 40 generally includes bottom plate 46, top plate 48, and support bars 50. Support bars 50 are mechanically attached to bottom plate 46 and top plate 48 and connect bottom plate 46 and top plate 48 together. Wax mold 38 is first positioned on bottom plate 46 such that first end 18 of ceramic seed well 10 rests on bottom plate 46. Top plate 48 is then positioned relative to wax mold 38 such that top plate 48 abuts wax pour cup 36, or second end 34 of wax pattern 30. Bottom plate 46 and top plate 48 are secured to support bars 50 in any suitable manner (i.e., by bolts) to maintain wax mold 38 securely between bottom plate 46 and top plate 48. Although fixture 40 is depicted in FIG. 3 as including bottom plate 46, top plate 48, and two support bars 50, fixture 40 may take any form without departing from the intended scope of the invention as long as wax mold 38 is held securely onto fixture 40. For example, fixture 40 may optionally not include top plate 48 or may include a different number of support bars 50. In addition, support bars 50 of different lengths may be used to account for wax molds of varying heights without departing from the intended scope of the present invention.

FIG. 3A shows a second embodiment of fixture 40 having multiple gated wax patterns 30 with attached ceramic seed wells 10 assembled on fixture 40 and attached to a single pour cup 36.

Once wax mold 38 is held securely within fixture 40, fixture 40 is lowered into slurry tank 44 to coat a first layer of ceramic material 42 over wax mold 38. Fixture 40 with wax mold 38 is repeatedly dipped into slurry tank 44 to form continuous layers of ceramic material 42 over wax mold 38. Coated wax mold 38 is then placed into a machine that applies dry ceramic onto the still wet coat of ceramic material 42 from slurry tank 44. Typically, each layer of ceramic material 42 is allowed to dry before dipping wax mold 38 back into slurry tank 44. In an exemplary embodiment, ceramic material 42 is coated onto wax mold 38 until ceramic material 42 has a thickness of between approximately 0.25 inches (6.4 mm) and approximately 0.5 inches (13 mm). Because first end 18 of ceramic seed well 10 and second end 34 of wax pattern 30 engage bottom plate 46 and top plate 48, respectively, first end 18 of ceramic seed well 10 and second end 34 of wax pattern 30 are not coated with ceramic material 42. Only the sides of wax mold 38 are coated with ceramic material 42. Although wax mold 38 is discussed as being dipped into slurry tank 44 to coat ceramic material 42 onto wax mold 38, wax mold 38 may be coated with ceramic material 42 by any means known in the art without departing from the intended scope of the present invention.

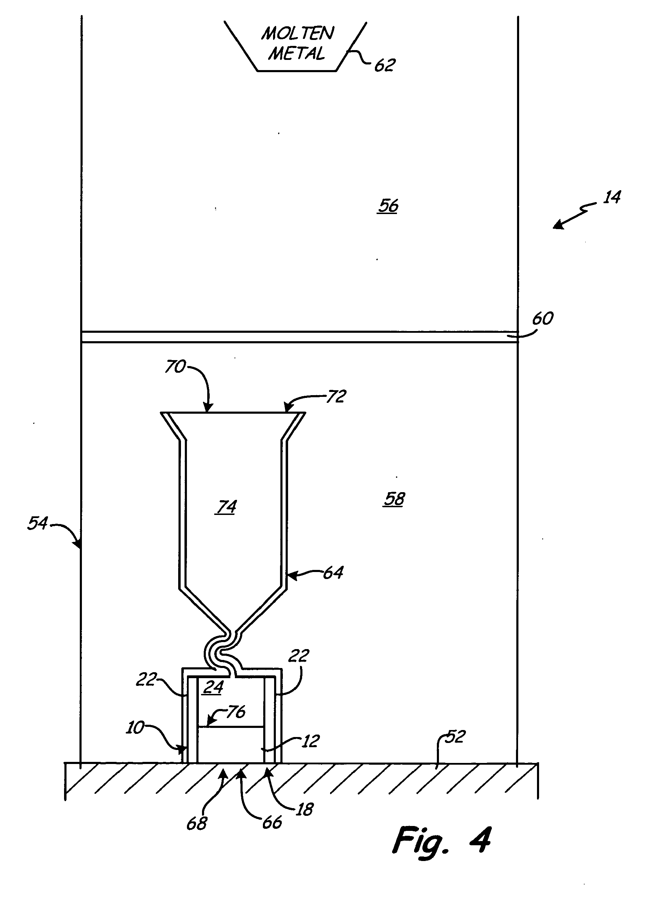

FIG. 4 shows a schematic view of a third step in investment casting process 14 and generally includes chill plate 52, furnace 54 having hot chamber 56 and cold chamber 58 separated by thermal baffle 60, and molten metal supply 62. After ceramic material 42 has been adequately coated onto wax mold 38 (shown in FIG. 3), bottom and top plates 46 and 48 of fixture 40 (shown in FIG. 3) are unbolted from bars 50 to release wax mold 38 coated with ceramic material 42. Wax mold 38 coated with ceramic material 42 is then heated to melt the wax forming wax plug 26, wax gating 28, wax pattern 30, and wax pour cup 36. The wax is then poured out of ceramic material 42. The wax may be removed by any means known in the art. Although wax plug 26, wax gating 28, wax pattern 30, and wax pour cup 36 are discussed as being formed of wax, wax plug 26, wax gating 28, wax pattern 30, and wax pour cup 36 may be formed of any meltable material.

Once the wax is removed, ceramic material 42 is then fired to harden ceramic material 42 and form ceramic mold 64. Ceramic mold 64 thus takes the shape of ceramic seed well 10, wax gating 28, wax pattern 30, and wax pour cup 36. Ceramic mold 64 has a first opening 66 at a first end 68 of ceramic mold 64 and a second opening 70 at a second end 72 of ceramic mold 64. First opening 66 of ceramic mold 64 overlaps the opening at first end 18 of ceramic seed well 10. In addition, cavity 74 is left within ceramic mold 64. Ceramic mold 64 is then positioned in hot chamber 56 of furnace 54 and heated to a temperature higher than the melting point of the molten metal used to form the casting. In an exemplary embodiment, hot chamber 56 is at a temperature of between approximately 2600 degrees Fahrenheit (°F) and approximately 3000 °F (1650 °C). Chill plate 52 is positioned within furnace 54 and is used to extract heat from ceramic mold 64. Prior to positioning ceramic mold 64 on chill plate 52, seed 12 is positioned within first end 18 of ceramic seed well 10. Seed 12 and ceramic mold 64 are then positioned upon chill plate 52 such that seed 12 is positioned on chill plate 52 with side walls 22 of ceramic seed well 10 around seed 12. Ceramic seed well 10 must also have a height greater than seed 12 such that a small amount of seed 12 can melt-back upon contact with the molten metal. Before casting, ceramic mold 64 is raised into hot chamber 56 of furnace 54 to where seed 12 is positioned at the bottom of hot chamber 56. Molten metal is poured through second opening 70 of ceramic mold 64 from molten metal supply 62. When the molten metal is poured into ceramic mold 64, solidification does not initially occur within cavity 74 of ceramic mold 64 or at walls 22 of ceramic seed well 10 because ceramic mold 64 is at a higher temperature than the molten metal. Solidification only occurs beginning at the melt-back of top surface 76 of seed 12, once ceramic mold 64 is lowered from hot chamber 56 down into cold chamber 58 while heat is extracted from ceramic mold 64 into chill plate 52.

Seed 12 is used to produce a single crystal casting. Because seed 12 is machined from a pre-existing single crystal of a material having a similar melting point as the molten metal, when the molten metal is introduced into ceramic mold 64, the molten metal reaches seed 12 and melts a small portion of top surface 76 of seed 12. The liquid atoms created when seed 12 melts use the underlying structure of the solid atoms of seed 12 and continue to grow in the same orientation as the "seeded" orientation through epitaxial crystal growth. As solidification proceeds, crystal growth continues directionally upward in a direction opposite to the heat extraction (chill plate 52). To aide this directional alignment of upward growing crystal, ceramic mold 64 is withdrawn vertically from hot chamber 56 and placed into cold chamber 58, which is typically positioned below and thermally separated from hot chamber 56 to allow solidification to progress at a uniform rate while aligning the crystals in a directional manner. In an exemplary embodiment, cold chamber 58 is at ambient temperature. In addition, although cold chamber 58 is depicted in FIG. 4 as being an integral part of furnace 54, furnaces that promote directional crystal growth may also be used without departing from the intended scope of the present invention.

The epitaxial orientation is maintained throughout the casting by controlling the temperature parameters of furnace 54 and the rate by which ceramic mold 64 is withdrawn from hot chamber 56 and positioned in cold chamber 58 of furnace 54. In addition, the helical shape formed by wax gating 28 (shown in FIG. 2) aids in producing a single crystal casting of the desired orientation by blocking the growth of any secondary grains that may have spontaneously nucleated as the solidification front moved up and away from the seed in a directional manner through the helix. The dominant crystal continues to branch out to fill the entire cavity 74, producing a directionally solidified, single crystal with directionality in the growth direction. Thus, the resultant seeded single crystal casting has two directions of atomic orientation. In addition, wax gating 28 (shown in FIG. 3) attached to ceramic seed well 10 serves as a grain selector which aids in ensuring single crystal growth by excluding all but one columnar grain as the casting is solidified in a directional manner through the helix if seed 12 fails to create epitaxial growth. The grain selector (wax gating 28) may or may not be used depending on the success of seed 12 in creating epitaxial growth. In addition, the shape of the grain selector may be any variety of shapes and sizes that are known in the art.

As previously mentioned, it is important that there is no gap between seed 12 and walls 22 of ceramic seed well 10. Thus, by preforming ceramic seed well 10 through an extrusion, injection slip cast, or similar process and firing ceramic seed well 10 prior to coating ceramic seed well 10 with ceramic material 42, the shrinkage problems that occur when wax mold 38 is heated to remove wax mold 38 and is then fired to form ceramic mold 64, and when ceramic mold 64 is maintained within hot chamber 56 and cold chamber 58, are alleviated.

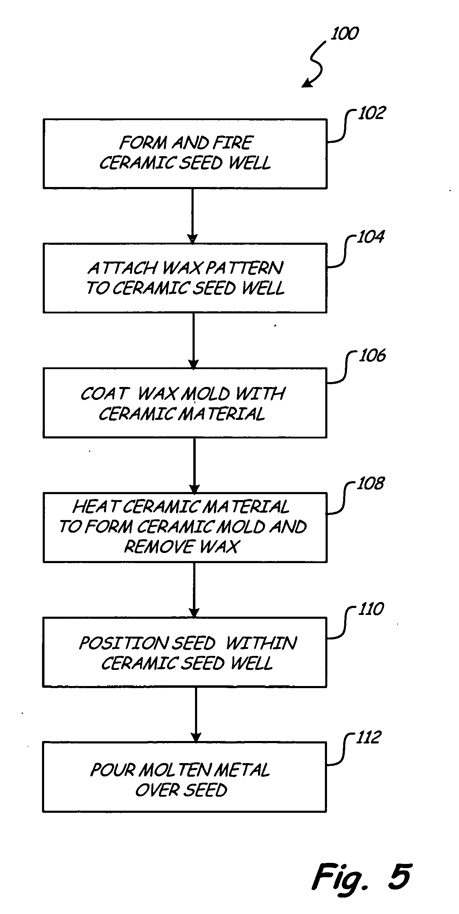

FIG. 5 shows a diagram of a method 100 of fabricating a casting using preformed ceramic seed well 10. Ceramic seed well 10 is first formed from ceramic and fired to maintain its dimensions, Box 102. In an exemplary embodiment, ceramic seed well 10 is formed through an extrusion process. Wax plug 26 is then positioned within ceramic seed well 10 to help facilitate attachment of wax gating 28 and wax pattern 30 to ceramic seed well 10, Box 104. In an exemplary embodiment, wax gating 28 is positioned between ceramic seed well 10 and wax pattern 30 and is attached to wax plug 26 within ceramic seed well 10 with an adhesive. As shown in Box 106, wax mold 38 is then coated with ceramic material 42 from slurry tank 44 and coated with dry ceramic. This step may be repeated as many times as desired, depending on the desired thickness of the resulting mold 64. In an exemplary embodiment ceramic material 42 is coated onto wax mold 38 to a thickness of between approximately 0.25 inches and approximately 0.5 inches (13 mm). Ceramic material 42 is then removed from fixture 40 and heated to remove the wax forming wax plug 26, wax gating 28, and wax pattern 30 and fired to harden ceramic material 42 to form ceramic mold 64, Box 108. After the wax has been removed from ceramic mold 64 and ceramic material 42 has been fired, seed 12 is positioned within ceramic seed well 10, Box 110. In an exemplary embodiment, seed 12 has selected primary and secondary orientations and is sized to fit precisely within inner area 24 of ceramic seed well 10. Ceramic mold 64 and seed 12 are positioned on chill plate 52 and molten metal is poured over seed 12 within ceramic seed well 10 and cavity 74 of ceramic mold 64, Box 112. Ceramic mold 64 must initially be maintained at a temperature higher than the melting point of the molten metal such that the molten metal contacting the surfaces of ceramic mold 64 does not begin to solidify. As heat is extracted through chill plate 52, a casting is formed within mold cavity 74 from seed 12, forming a single crystal casting.

The preformed ceramic seed well replaces the wax or plastic seed well typically used in investment casting processes. The preformed ceramic seed well is formed through an extrusion process and is dimensioned to match the dimensions of a seed having particular primary and secondary orientations. By preforming the ceramic seed well, various process variations are eliminated and thermal conditions adjacent to the seed may be customized to enhance the melt back control of the seed. In addition, the ceramic seed well is fired prior to being subjected to numerous heating steps in the investment casting process, removing several tolerances and shrinks. In addition, flow across the seed surface is increased, reducing localized oxidation. These advantages result in a tighter, more consistent fit of the seed within the seed well and increase the yield on expensive cast parts.

Although the present invention has been described with reference to preferred embodiments, workers skilled in the art will recognize that changes may be made in form and detail without departing from the scope of the invention, which is defined by the claims and their equivalents.

## Claims

1. An investment casting process comprising:
attaching a first wax pattern (30) to a first preformed seed well (10);
coating the first wax pattern and the first preformed seed well with at least one layer of ceramic material (42) to form a first ceramic mold;
heating the first ceramic mold to melt and remove the first wax pattern;
firing the first ceramic mold to form a first hardened ceramic shell;
placing a first seed (12) within the first preformed seed well; and
pouring molten metal (62) into the first hardened ceramic shell and the first preformed seed well.

2. The process of claim 1, wherein heating the ceramic mold to form a hardened ceramic shell comprises positioning the ceramic mold within a furnace.

3. The process of claim 1 or 2, and further comprising positioning the ceramic mold on a chill plate.

4. The process of claim 1, 2 or 3, wherein the preformed seed well is formed of a material selected from the group consisting of: ceramic, metal, and composite material.

5. The process of claim 1, 2, 3, or 4, wherein the preformed ceramic seed well is formed by one of the group consisting of: extrusion processing, injection processing, and slip cast processing.

6. The process of any preceding claim, wherein attaching the wax pattern to the preformed seed well comprises attaching the wax pattern to a wax plug (26) positioned within an interior area of the preformed seed well (10).

7. The process of any preceding claim, wherein pouring molten metal into the preformed seed well comprises pouring the molten metal over the seed.

8. The process of any preceding claim, wherein placing the seed within the preformed seed well comprises utilizing a seed having selected primary and secondary orientations.

9. The process of any preceding claim, wherein the preformed seed well has a height greater than a height of the seed.

10. The process of any preceding claim, and further comprising positioning the seed well on a chill plate.

11. The process of any preceding claim, and further comprising coating the first wax pattern and first preformed seed well with a plurality of layers of ceramic material to form a ceramic mold.

12. The process of any preceding claim, wherein attaching the wax pattern to the preformed, ceramic seed well comprises attaching a wax gating (28) of the wax pattern to the preformed seed well.

13. The process of any preceding claim, and further comprising:
attaching at least a second wax pattern to a second preformed seed well;
coating the second wax pattern and the second preformed seed well with at least one layer of ceramic material to form a second ceramic mold;
heating the second ceramic mold to melt and remove the second wax pattern;
firing the second ceramic mold to form a second hardened ceramic shell;
placing a second seed within the second preformed seed well; and
pouring molten metal into the second hardened ceramic shell and the second preformed seed well;
wherein attaching the second wax pattern, coating the second wax pattern and the second preformed seed well to form a second ceramic mold, heating the second ceramic mold to melt and remove the second wax pattern, firing the second ceramic mold to form a second hardened ceramic shell, placing a second seed within the second preformed seed well, and pouring molten metal into the second hardened ceramic shell and the second preformed seed well occur simultaneously with attaching the first wax pattern, coating the first wax pattern and the first preformed seed well to form a first ceramic mold, heating the first ceramic mold to melt and remove the first wax pattern, firing the first ceramic mold to form a first hardened ceramic shell, placing a first seed within the first preformed seed well, and pouring molten metal into the first hardened ceramic shell and the first preformed seed well, respectively.

14. The process of any preceding claim, wherein multiple wax patterns are attached to multiple preformed seed wells.

15. The process of any preceding claim, wherein multiple wax patterns are coated to form ceramic molds.
